# EUROPÄISCHE PATENTSCHRIFT

(11) **EP 3 001 781 B1**
(45) Veröffentlichungstag und Bekanntmachung des Hinweises auf die Patenterteilung: **02.12.2020**
(21) Anmeldenummer: 15178723.1
(22) Anmeldetag: 28.07.2015
(51) Int. Cl.: H05K 3/12, B41F 15/08, B41F 15/26

(54) **DRUCKSYSTEM UND VERFAHREN ZUM BEDRUCKEN VON SUBSTRATEN**
METHOD AND PRINTING SYSTEM FOR PRINTING ON SUBSTRATES
DISPOSITIF D'IMPRESSION ET PROCEDE DESTINES A L'IMPRESSION DE SUBSTRATS

(30) Priorität: 30.07.2014 DE 102014215022
(43) Veröffentlichungstag der Anmeldung: 30.03.2016
(73) Patentinhaber: Ekra Automatisierungssysteme GmbH, 74357 Bönnigheim (DE)
(72) Erfinder: Brosi, Ralf, 71723 Großbottwar (DE); Krause, Gerd, 74369 Löchgau (DE); Mang, Klaus, 89143 Blaubeuren (DE); Irlbacher, Günther, 92539 Schönsee (DE)
(74) Vertreter: Clarenbach, Carl-Philipp

(56) Entgegenhaltungen:
- GB-A- 2 497 882
- US-A1- 2013 063 709

## Beschreibung

Die Erfindung betrifft ein Drucksystem zum Bedrucken von Substraten, insbesondere Leiterplatten, mit einer Druckeinrichtung, die wenigstens einen Drucktisch und eine dem Drucktisch zugeordnete Druckschablone aufweist, und mit Mitteln zum Ausrichten eines Substrats auf dem Drucktisch.

Ferner betrifft die Erfindung ein Verfahren zum Betreiben des oben beschriebenen Drucksystems.

Heutige Drucksysteme, wie sie bei der Bearbeitung von Leiterplatten, Keramikplatten, Solarzellen, Folien oder dergleichen häufig Anwendung finden, arbeiten nach dem Prinzip, dass Substrate nacheinander über eine Zuführung einer Druckeinrichtung zugeführt und in der Druckeinrichtung bezüglich einer Druckschablone ausgerichtet, bedruckt und anschließend abgeführt werden. Für das Ausrichten ist es bekannt, Kameras und Bildauswertungssysteme vorzusehen, die das Substrat optisch erfassen, um dann in Kenntnis von der Anordnung der Kamera(s) zu der Druckschablone das Substrat optimal zu der Druckschablone ausrichten zu können. Hierzu ist es beispielsweise bekannt, einen Drucktisch, auf welchem das Substrat zum Drucken aufliegt, zu verschieben und/oder zu verdrehen, bis das Substrat deckungsgleich zu der Druckschablone liegt. Erst dann wird ein Druckvorgang, beispielsweise mittels eines Rakels der Druckeinrichtung durchgeführt, bei welchem das Druckmedium durch die Druckschablone, die beispielsweise ein Drucksieb oder eine Druckmaske ist, auf das Substrat aufgebracht wird.

Die optische Erfassung der Ausrichtung des Substrats beziehungsweise der Substrate bietet eine sehr hohe Genauigkeit und erlaubt die Verarbeitung verschiedenster Arten und Formen von optischen Orientierungs- und/oder Erkennungsmarken, die auf den Substraten aufgebracht sind. Nach erfolgtem Druckvorgang wird das Substrat von der Druckeinrichtung wieder entfernt und gegebenenfalls vorab oder anschließend darauf geprüft, ob der Druckvorgang erfolgreich ausgeführt wurde. Das optische Erfassen des oder der Substrate hat jedoch den Nachteil, dass auf den Substraten und gegebenenfalls auch auf der Druckschablone jeweils optische Orientierungsmarken aufgebracht sein müssen. Bei transparenten Flächen von Substraten ist es jedoch nicht immer möglich, optisch erfassbare Orientierungsmarken zu platzieren. Auch folgt durch das Vorsehen von Orientierungsmarken auf dem Substrat, dass im Bereich der Orientierungsmarke(n) keine sonstigen Elemente, wie beispielsweise Schaltungselemente oder dergleichen vorgesehen werden können, was die Ausnutzung der Oberfläche des Substrats beim Druck einschränken kann.

Aus der Offenlegungsschrift GB 2 497 882 A ist ein Drucksystem bekannt, bei welchem ein Drucktisch mehrstufig ausgebildet ist, wobei die mehreren Stufen in unterschiedliche Richtungen zur Positionierung eines Substrats verfahrbar sind. Auf der Oberfläche des Drucktischs ist außerdem eine Klemmeinrichtung mit einem verschiebbaren Klemmelement angeordnet.

Aus der Offenlegungsschrift US 2013/0063709 A1 ist weiterhin ein System bekannt, bei welchem einer Positionierungsoberfläche mehrere Schiebereinheiten, die jeweils eine Antriebseinrichtung und ein Schieberelement aufweisen, zugeordnet sind, um ein Substrat auf der Positionierfläche beliebig zu verschieben.

Der Erfindung liegt die Aufgabe zugrunde, ein Drucksystem zu schaffen, das auf einfache Art und Weise die oben genannten Nachteile überwindet und eine kostengünstige und effiziente Ausrichtung von Substraten auf einem Drucktisch ermöglicht.

Die der Erfindung zugrundeliegende Aufgabe wird durch ein Drucksystem mit den Merkmalen des Anspruchs 1 gelöst. Dieses hat den Vorteil, dass auf eine optische Erfassung des Substrats gänzlich verzichtet werden kann. Vielmehr ist vorgesehen, dass eine Erfassung und Ausrichtung des Substrats mechanisch erfolgt. Erfindungsgemäß ist hierzu vorgesehen, dass die Mittel ein erstes Paar von zwei entlang einer ersten Achse gegenläufig zueinander verlagerbaren ersten Schieberelementen und ein zweites Paar entlang einer zweiten, von der ersten Achse abweichenden Achse gegenläufig zueinander verlagerbaren zweiten Schieberelementen aufweisen, wobei jedem Paar zumindest eine Antriebseinrichtung zum gleichzeitigen Verlagern seiner Schieberelemente zugeordnet ist. Es ist also vorgesehen, dass zumindest zwei mal zwei Schieberelemente vorgesehen sind, wobei jeweils zwei Schieberelemente entlang einer Achse gegenläufig zueinander verlagerbar sind, und wobei die beiden Achsen voneinander abweichen, so dass sich die Schieberelemente eines Paares entlang einer Richtung bewegen und die Schieberelemente des anderen Paares in einer anderen Richtung. Dadurch ist es möglich, ein Substrat zwischen die Schieberelemente zu legen, wenn sich diese in ihrer Ausgangsstellung befinden, und beim Zusammenfahren der Paare von Schieberelementen das Substrat zwischen dem Schieberelement eines Paares jeweils zu ver spannen. Dadurch, dass die Schieberelemente eines Paares aufeinander zu bewegt werden, wird das Substrat bezüglich dieser Schieberelemente automatisch ausgerichtet. Werden zuerst die ersten Schieberelemente und anschließend die zweiten Schieberelemente entsprechend aufeinanderzu bewegt, lässt sich dadurch eine eindeutige Ausrichtung des Substrats auf dem Drucktisch erreichen. Insbesondere wird dabei vorausgesetzt, dass die Außenkontur des zu bedruckenden Substrats bekannt ist, so dass beispielsweise in Abhängigkeit von dem Abstand der ersten Schieberelemente und/oder der zweiten Schieberelemente zueinander feststellbar ist, ob das Substrat korrekt zwischen den Schieberelementen liegt, oder ob das korrekte Substrat auf den Drucktisch aufgelegt wurde. Es erfolgt durch das erfindungsgemäße Drucksystem also eine mechanische Ausrichtung und insbesondere Zentrierung der Substrate beziehungsweise des Substrates auf dem Drucktisch, bei welcher auf ein aufwändiges visuelles beziehungsweise optisches Erfassen von Orientierungsmarken oder dergleichen verzichtet werden kann. Durch das Zusammenfahren der ersten Schieberelemente und der zweiten Schieberelemente wird erreicht, dass das Substrat automatisch richtig ausgerichtet wird. Durch ein Verfahren des Drucktischs kann anschließend bevorzugt noch die Absolutposition des Substrats zu der Druckschablone optimiert werden. Vorzugsweise ist vorgesehen, dass die Schieberelemente jeweils von einer Ausgangsstellung aus in Richtung des Substrats verfahrbar sind. Die jeweiligen Ausgangsstellungen sind dabei derart gewählt, dass, wenn sich die Schieberelemente in ihren Ausgangsstellungen befinden, sich ein Substrat zwischen die Schieberelemente beziehungsweise den Bereich zwischen den Schieberelementen auf den Drucktisch auflegen lässt. Zweckmäßigerweise stellen die Ausgangsstellungen die Stellung der Schieberelemente dar, bis zu welcher die Schieberelemente eines Paares maximal auseinander gefahren werden können.

Gemäß einer vorteilhaften Weiterbildung der Erfindung ist vorgesehen, dass die erste und die zweite Achse zumindest im Wesentlichen senkrecht zueinander ausgerichtet sind. Insbesondere ein quadratisches und/oder rechteckförmiges Substrat wird dadurch auf einfache Art und Weise mittels des Drucksystems ausgerichtet. Die Schieberelemente weisen zweckmäßigerweise eine derartige Breite auf, dass sie einen sicheren Anlagekontakt an dem Substrat gewährleisten. Jedes der Schieberelemente kann eine oder mehrere Anlagestellen für das Substrat aufweisen. Die Anlagestellen eines Schieberelementes liegen dabei zweckmäßigerweise in einer Ebene. Für den Fall, dass das Substrat eine von einem Rechteck abweichende Außenkontur aufweist, kann auch vorgesehen sein, dass eine oder mehrere der Anlagestellen eines Schieberelementes in einer von der Ebene abweichenden zweiten Ebene liegen, um einen optimalen Anlagekontakt und ein optimales Ausrichten des Substrats zu der Druckschablone zu ermöglichen.

Ferner ist erfindungsgemäß vorgesehen, dass die Schieberelemente des jeweiligen Paares zu ihrer Verlagerung mechanisch miteinander gekoppelt sind. Durch die mechanische Kopplung wird erreicht, dass mittels einer einzigen Antriebseinheit beide Schieberelemente eines Paares von Schieberelementen verlagert beziehungsweise aufeinander zu bewegt werden können. Durch die mechanische Kopplung kann somit auf schieberelementindividuelle Antriebseinrichtungen verzichtet und dadurch der Kosten- und Herstellungsaufwand verringert werden. Die mechanische Kopplung erfolgt bevorzugt durch eine Spindel, die mit beiden Schieberelementen eines Paares wirkverbunden ist und durch einen Elektromotor der Antriebseinrichtung antreibbar ist. Die Rotationsachse beziehungsweise Längsachse der Spindel stellt dabei vorzugsweise die erste oder zweite Achse des ersten beziehungsweise zweiten Paares von Schieberelementen dar. Sind die Antriebseinrichtungen beider Paare mit jeweils einer Spindel zu mechanischen Kopplung der jeweiligen Schieberelemente versehen, so liegen die Spindeln zweckmäßigerweise in unterschiedlichen Ebenen über- beziehungsweise untereinander. Zweckmäßigerweise ist die Kopplung derart ausgebildet, dass die Schieberelemente stets gegenläufig zueinander bei der Ansteuerung der Antriebseinrichtung verlagert werden.

Weiterhin ist bevorzugt vorgesehen, dass jedem Paar von Schieberelementen wenigstens ein Sensor zum Erfassen der Stellung zumindest eines der Schieberelemente zugeordnet ist. Hierdurch ergibt sich der Vorteil, dass die Position der Schieberelemente erfasst wird, und in Abhängigkeit von der Position das korrekte Ausrichten des Substrats verifiziert werden kann. Bevorzugt handelt es sich bei dem Sensor um einen der Antriebseinrichtung zugeordneten Stromsensor, der insbesondere den Versorgungsstrom des Elektromotors überwacht. Nimmt dieser plötzlich zu, so kann darauf geschlossen werden, dass die Schieberelemente des durch den Elektromotor angetriebenen Paares von Schieberelementen das Substrat zwischen sich eingeklemmt haben und nicht weiter verlagert werden können. Hierdurch wird also die Endstellung beziehungsweise die Endposition der Schieberelemente erfasst, in welcher das Substrat zwischen ihnen sicher verspannt ist. Eine absolute Position muss dabei nicht unbedingt ermittelt werden. Ist der Sensor zum Erfassen der absoluten Position der Schieberelemente ausgebildet, so kann die Kenntnis der absoluten Position beispielsweise dazu genutzt werden, die Größe des Substrats durch den Abstand der Schieberelementes des Paares zueinander zu verifizieren, wodurch die Betriebssicherheit der Produkteinrichtung weiter erhöht wird. Insbesondere ist vorgesehen, dass die Sensoren als Wegemesssensoren ausgebildet sind und ein Wegemesssystem bilden, um die absoluten Endpositionen der Schieberelemente auf dem Drucktisch zu bestimmen. Durch Kenntnis der absoluten Endstellungen lassen sich der Drucktisch und/oder die Schablone vorteilhaft zueinander ausrichten.

Ferner ist bevorzugt vorgesehen, dass eine Steuereinheit vorgesehen ist, die die Antriebseinheit zumindest einer der Paare derart zum Ausrichten des Substrats ansteuert, dass die Schieberelemente des Paares solange aufeinander zubewegt werden, bis das Substrat zwischen den Schieberelementen eingeklemmt ist. Dabei werden insbesondere die Ausgangssignale des Sensors zur Erfassung der Endstellung der Schieberelemente, wie zuvor beschrieben, genutzt. Sobald das Substrat zwischen allen Schieberelementen eingeklemmt ist, wird davon ausgegangen, dass die Ausrichtung des Substrats erfolgt ist beziehungsweise durchgeführt wurde.

Weiterhin ist bevorzugt vorgesehen, dass die Steuereinheit zunächst das erste Paar und anschließend das zweite Paar von Schieberelementen zum sequenziellen Ausrichten des Substrats ansteuert. Durch das nacheinander paarweise Verfahren der Schieberelemente wird erreicht, dass das Substrat sequenziell ausgerichtet wird, wodurch Konflikte beim Ausrichten vermieden werden.

Besonders bevorzugt ist vorgesehen, dass die Schieberelemente in den Drucktisch versenkbar angeordnet sind. Die Schiebereinrichtung mit dem ersten Paar und dem zweiten Paar von Schieberelementen ist somit in seiner Höhe bezüglich des Drucktisches verlagerbar angeordnet. Insbesondere ist vorgesehen, dass die Schieberelemente zumindest in ihrer jeweiligen Ausgangsstellung in ihrer Höhe bezüglich des Drucktisches verfahrbar sind. Dadurch ist es möglich, insbesondere während des Druckvorgangs, die Schieberelemente zu entfernen, so dass die Druckschablone auf das Substrat aufbringbar ist. Zweckmäßigerweise weist dazu der Drucktisch zumindest in der Ausgangsstellung der Schieberelemente für jedes Schieberelement eine entsprechende Öffnung auf, in welche das Schieberelement versenkbar ist. Es kann vorgesehen sein, dass sich die Öffnung von der Ausgangsstellung bis zu der Mitte des Drucktisches hin erstreckt, so dass das jeweilige Schieberelement in jeder Schiebestellung in den Drucktisch versenkbar oder von dem Drucktisch erhebbar ist. Es kann auch vorgesehen sein, dass die Öffnung nur im Bereich der Ausgangsstellung derart groß ausgebildet ist, dass sich die Schieberelemente nur dort versenken lassen. Dadurch werden die Schieberelemente in übrigen Verschiebebereichen durch den Drucktisch von unten gestützt. In jedem Fall ist vorzugsweise vorgesehen, dass der Drucktisch entlang der jeweiligen Achse eine Aussparung aufweist, durch welche ein Abschnitt des jeweiligen Schieberelementes, insbesondere ein Betätigungsarm zu seiner Betätigung hindurchgreift, damit das Schieberelement insbesondere unterhalb des Drucktischs mit der jeweiligen Spindel und/oder der jeweiligen mechanischen Kopplung beziehungsweise Antriebseinrichtung verbindbar ist.

Weiterhin ist bevorzugt vorgesehen, dass die Schieberelemente drehbar gelagert angeordnet sind. Dabei ist gemäß einer ersten Ausführungsform bevorzugt vorgesehen, dass die Schieberelemente frei drehbar gelagert sind, so dass sie sich selbst bei Anlagekontakt an dem Substrat selbst in ihrer Drehlage ausrichten. Alternativ ist vorzugsweise vorgesehen, dass die Schieberelemente gesteuert beziehungsweise regelbar motorisch verdrehbar sind, um beispielsweise ein gewünschte Ausrichtung des Substrats zu erhalten, die von einer einfachen zentrierten Ausrichtung abweicht.

Das erfindungsgemäße Verfahren zum Betreiben des Drucksystems mit den Merkmalen des Anspruchs 9 zeichnet sich dadurch aus, dass die Schieberelemente des ersten Paares aufeinander zubewegt werden, bis das Substrat zwischen den ersten Schieberelementen des ersten Paares geklemmt ist, und dass anschließend die zweiten Schieberelemente des zweiten Paares aufeinander zubewegt werden, bis das Substrat zwischen den zweiten Schieberelementen geklemmt ist. Es ergeben sich hierdurch die zuvor bereits genannten Vorteile. Weitere Merkmale und Vorteile ergeben sich aus dem zuvor Beschriebenen sowie aus den Ansprüchen.

Im Folgenden soll die Erfindung anhand eines Ausführungsbeispiels näher erläutert werden. Dazu zeigen:
- Figur 1: ein Drucksystem in einer vereinfachten Darstellung,
- Figur 2: eine Draufsicht auf einen Drucktisch des Drucksystems und
- Figur 3: eine vereinfachte Schnittdarstellung des Drucktischs.

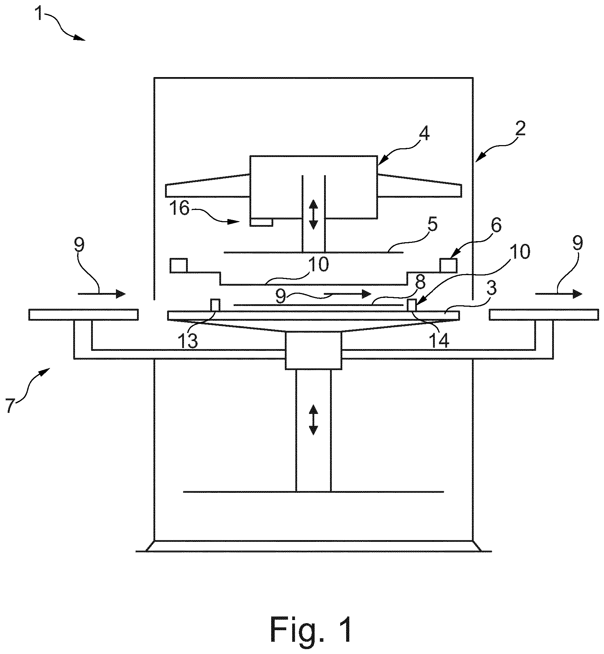

Figur 1 zeigt in einer vereinfachten Darstellung ein Drucksystem 1 zum Bedrucken von Substraten, wie beispielsweise Leiterplatten, Keramikplatten, Solarzellen, Folien oder dergleichen. Das Drucksystem 1 weist eine Druckeinrichtung 2 auf, die einen Drucktisch 3 sowie eine Rakeleinrichtung 4 mit wenigstens einem bewegbaren Rakel 5 aufweist. Der Drucktisch 3 und das Rakel 5 sind insbesondere höhenverstellbar ausgebildet, wie durch Doppelpfeile angedeutet. Die Druckeinrichtung 2 weist weiterhin eine Druckschablone 6 auf, die zwischen dem Rakel 5 und dem Drucktisch 3 angeordnet ist.

Weiterhin ist der Druckeinrichtung eine Transporteinrichtung 7 zugeordnet, die dazu ausgebildet ist, ein Substrat 8, das hier beispielhaft dargestellt ist, der Druckeinrichtung 2 zuzuführen, zwischen Schablone 6 und Drucktisch 3 durch die Druckeinrichtung 2 zu transportieren und vom Drucktisch 3 wieder abzuführen, wie durch Pfeile 9 angedeutet, die die Transportrichtung des Substrats 8 beziehungsweise der Transporteinrichtung 7 anzeigen.

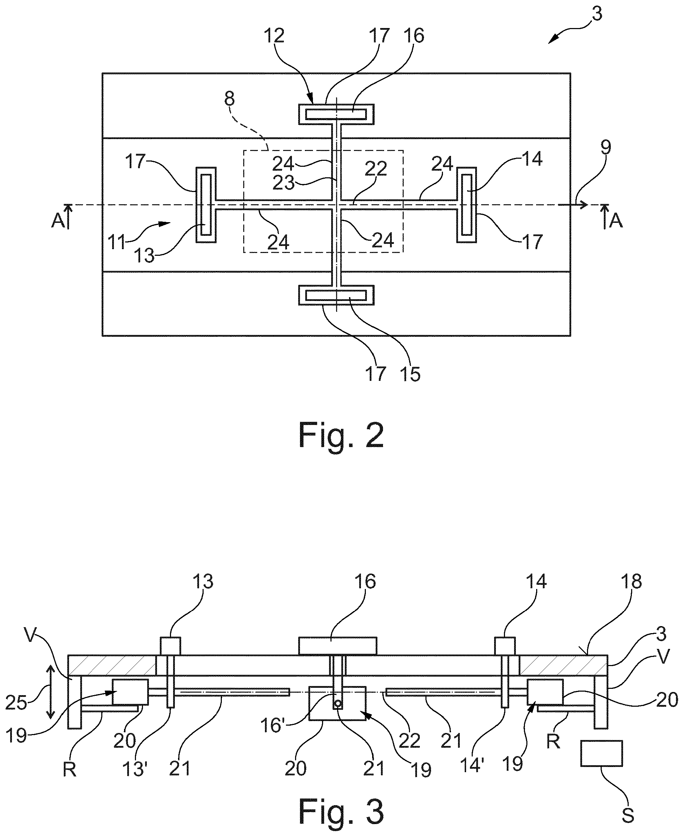

Dem Drucktisch 2 sind Mittel 10 zum Ausrichten des Substrats auf dem Drucktisch 3 insbesondere bezüglich der Druckschablone 6 zugeordnet, die im Folgenden anhand von Figuren 2 und 3 näher erläutert werden sollen.

Figur 2 zeigt eine Draufsicht auf den Drucktisch 3 des Drucksystems 1. Die Mittel 10 weisen zwei Paare 11, 12 mit jeweils zwei Schieberelementen 13, 14 beziehungsweise 15, 17 auf. Die Schieberelemente 13, 14 des Paares 11 sind dabei in Transportrichtung gemäß Pfeil 9 hintereinanderliegend angeordnet. Die Schieberelement 15, 16 des zweiten Paares 12 sind zwischen den Schieberelementen 13, 14 - in Transportrichtung 9 gesehen - einander gegenüberliegend angeordnet. Die Schieberelemente 13 bis 16 befinden sich gemäß Figur 2 dabei in einer jeweiligen Ausgangsstellung auf dem Drucktisch 3. Der Drucktisch 3 weist für jedes Schieberelement 13 bis 16 in seiner Ausgangsstellung eine Aussparung 17 auf, die mindestens so groß ausgebildet ist, wie das jeweilige Schieberelement 13 bis 16.

Figur 3 zeigt eine Längsschnittdarstellung des Drucktisches 3 entlang der Linie A-A aus Figur 2. Die Schieberelemente 13 bis 16 ragen von der Oberseite 18 des Drucktischs 3 hervor. Jedes Schieberelement 13 bis 16 weist dabei einen durch den Drucktisch 3 beziehungsweise die jeweilige Aussparung 17 hindurchführenden Betätigungsarm 13', 16' und 14' auf. Selbstverständlich weist auch das Schieberelement 15 einen entsprechenden Betätigungsarm 15' auf, der in der Darstellung jedoch nicht sichtbar ist. Die Betätigungsarme 13', 14', 16' durchgreifen somit den Drucktisch 3. An der Unterseite des Drucktischs 3 ist für jedes der Schieberelemente 13 bis 16 jeweils eine Antriebseinrichtung 19 vorgesehen, die jeweils einen Elektromotor 20 sowie eine von dem Elektromotor 20 antreibbare Spindel 21 aufweist. Die Spindeln 21 sind parallel zur Oberseite 18 des Drucktischs 3 ausgerichtet. Dabei sind die Spindeln 21 jeweils eines Paares 11, 12 von Schieberelementen 13, 14 beziehungsweise 15, 16 entlang einer gemeinsamen Drehachse ausgerichtet. Die gemeinsame Drehachse bildet dabei eine Achse 22 beziehungsweise 23, entlang welcher die Schieberelemente eines Paares auf dem Drucktisch 3 verfahrbar beziehungsweise verlagerbar sind. Die Drehachsen der beiden Paare können dabei auf der gleichen Höhe oder versetzt zueinander, wie in Figur 3 gezeigt, angeordnet sein. Dabei sind die Betätigungsarme 13', 16', 14', 15' derart mit der jeweiligen Spindel 21 wirkverbunden, dass durch eine antreibende Spindel 21 durch den jeweiligen Elektromotor 20 das entsprechende Schieberelement 13, 14, 15, 16 entlang der jeweiligen Achse 22, 23, verschoben wird. Dazu ist vorgesehen, dass in dem Drucktisch 3 ausgehend von den Aussparungen 17 jeweils Führungsschlitze 24 vorgesehen sind, die parallel zu der jeweiligen Achse 22, 23 ausgerichtet sind, und entlang welcher der jeweilige Betätigungsarm 13', 14', 16', (15') verfahrbar ist. Vorliegend ist vorgesehen, dass die Führungsschlitze 24 schmaler ausgebildet sind als die Schieberelemente 13 bis 16, so dass die Schieberelemente 13 bis 16 mit ihrer Unterseite auf der Oberseite 18 des Drucktischs 3 gleiten, wenn sie ihre Ausgangsstellung gemäß Figur 2 verlassen haben. Den Elektromotoren ist dabei eine gemeinsame, hier nur angedeutete Steuereinheit S zu deren koordiniertem Antrieb zugeordnet. Die Steuereinheit S überwacht dabei auch den von dem jeweiligen Elektromotor 20 aufgenommenen Strom und dient insofern als Stromsensor, dessen Funktion später näher erörtert wird.

Die Schiebereinheiten, bestehend aus jeweils einer Antriebseinrichtung 19 und einem Schieberelement 13 bis 16, sind vorteilhafterweise senkrecht zu dem Drucktisch 3 verlagerbar, wie durch einen Doppelpfeil 25 angedeutet. Insbesondere ist vorgesehen, dass die Schiebereinheiten an einem gemeinsamen Rahmen R gehalten sind, der beispielsweise an der Unterseite des Drucktischs 3 angeordnet und durch eine Verstelleinrichtung V senkrecht zu dem Drucktisch 3 verfahrbar ist. Durch die Ausbildung der Aussparungen 17 und der Führungsschlitze 24 ist vorliegend vorgesehen, dass das Verlagern der Schiebereinheiten nur dann möglich ist, wenn die Schieberelemente 13 bis 16 sich in ihrer Ausgangsstellung im Bereich der Aussparungen 17 befinden. Insbesondere ist vorgesehen, dass die Schieberelemente 17 derart weit in den Drucktisch 3 versenkbar sind, dass sie bündig mit der Oberseite 18 des Drucktischs 3 abschließen.

Im Betrieb des Drucksystems 1 wird das Substrat 8 dem Drucktisch 3 zugeführt, wie zuvor bereits erläutert. Dabei sind die Schieberelemente, zumindest aber das Schieberelement 13 in den Drucktisch 3 versenkt angeordnet, so dass das Substrat 8 auf dem Drucktisch 3 zwischen den Schieberelementen 13 bis 16 platzierbar ist, wie in Figur 2 gestrichelt dargestellt. Sobald das Substrat 8 sich zwischen den Schieberelementen 13 bis 16 befindet, werden diese oder das eine versenkte Schieberelement angehoben, so dass die Schieberelemente 13 bis 16 das Substrat 8 seitlich überragen. Anschließend steuert die Steuereinheit S die Elektromotoren 20 der Antriebseinrichtung 19 derart an, dass zunächst die Schieberelemente 13, 14 des Paares 11 zusammengeschoben werden, bis die Schieberelemente 13, 14 an dem Substrat 8 anliegen, so dass dieses zwischen den Schieberelementen 13, 14 verklemmt ist. Die Position der Schieberelemente 13, 14, in welcher das Substrat 8 verklemmt ist, wird durch Stromüberwachung der Elektromotoren 20 der entsprechenden Antriebseinrichtungen 19 ermittelt. Wenn der von den jeweiligen Elektromotoren 20 aufgenommen Strom plötzlich zunimmt, wird dies als Indikator dafür verstanden, dass das Substrat 8 zwischen den beiden Schieberelementen 13, 14 verklemmt ist. Wird bei nur einem der Elektromotoren ein erhöhter Stromwert erfasst, so kann dies zwei Ursachen haben. Entweder liegt nur eines der Schieberelemente 13 oder 14 an dem Substrat 8 an und verfährt beziehungsweise verschiebt dieses in Richtung des gegenüberliegenden Schieberelementes 14, 13, oder es ist ein Fehler im System, weil beispielsweise eines der Schieberelemente 13, 14 verklemmt ist und sich dadurch unabhängig von dem Substrat 8 nicht verfahren lässt. In diesem Fall wird eine Warnung ausgegeben. Um zwischen den beiden Situationen unterscheiden zu können, ist vorgesehen, dass der erfasste Stromwert mit einem Schwellwert verglichen wird, so dass erst bei Überschreiten des vorgebbaren Schwellwertes darauf geschlossen wird, dass ein Fehler im System vorliegt. Nimmt der Strom beider Elektromotoren 20 plötzlich zu, so wird auch diese Stromzunahme mit dem vorgebbaren Schwellwert verglichen und ein weiteres Ansteuern der Elektromotoren unterbrochen, wenn die Stromaufnahme den vorgebbaren Grenzwert überschreitet, der dann darauf hindeutet, dass das Substrat 8 zwischen dem Schieberelement 13, 14 verspannt ist.

Anschließend wird mit den Schieberelementen 15, 16 durch Ansteuerung der entsprechenden Elektromotoren 20 entsprechend vorgegangen. Dadurch wird das Substrat 8 insgesamt sequenziell auf dem Drucktisch 3 ausgerichtet. Zweckmäßigerweise werden die einander gegenüberliegenden Schieberelemente 13, 14 beziehungsweise 15, 16 des jeweiligen Paares 11, 12 gleichzeitig und gleichmäßig aufeinander zugefahren, bis keine weitere Bewegung mehr möglich ist. Alternativ oder zusätzlich zu der Stromüberwachung durch die Steuereinheit ist es auch denkbar, den Schieberelementen Sensoren zuzuordnen, die durch ein Wegemesssystem die Überwachung der Bewegung der Schieberregler 13 bis 16 durchführen.

Sobald festgestellt wurde, dass die Schieberelemente 13 bis 16 ihre Endposition erreicht haben und dass das Substrat entsprechend ausgerichtet wurde, werden die Schieberelemente 13 bis 16 wieder ein Stück zurückgefahren beziehungsweise vom Substrat 8 wegbewegt. Insbesondere werden die Schieberelemente zurück in ihre Ausgangsstellung bewegt und in dem Drucktisch 3 mittels der Verstelleinrichtung V versenkt. Anschließend wird der Drucktisch 3 in Richtung der Schablone 6 oder die Druckschablone 6 in Richtung des Drucktischs 3 verfahren, um den zuvor beschriebenen Druckvorgang durchzuführen.

Vorteilhafterweise wird durch ein die Wegemesssensoren aufweisendes Messsystem 26 die Position der Schieberelemente 13 bis 16 auf dem Drucktisch in ihrer Endposition ermittelt. Dies kann beispielsweise in Abhängigkeit von der Stromüberwachung und/oder durch optische Sensoren oder dergleichen erfolgen. In Kenntnis der Position der Schieberelemente 13 bis 16 ist auch die Lage des Substrats 8 auf dem Drucktisch 3 bekannt. Mit dieser Information wird nun die Druckschablone 6 zu dem Drucktisch 3 ausgerichtet, indem entweder der Drucktisch 3 oder die Druckschablone 6 mit dem Rakel 5 zu dem Drucktisch 3 ausgerichtet werden. Dazu sind der Drucktisch 3 einerseits und/oder die Druckschablone 6 und das Rakel 5 andererseits in einer Ebene parallel zur Oberseite 18 des Drucktischs 3 zur Positionierung/Ausrichtung verschiebbar und/oder verschwenkbar ausgebildet.

Durch die mechanische Ausrichtung des Substrats 8 mittels der Mittel 10 wird somit einerseits das Substrat 8 ausgerichtet und andererseits die Position des Substrats 8 auf dem Drucktisch 3 verifiziert oder ermittelt. Dadurch erfolgt auf einfache und kostengünstige Art und Weise eine schnelle und präzise Ausrichtung des Substrats 8 bezüglich der Druckschablone 6, wobei dies unabhängig von der Größe und Form des zu bedruckenden Substrats 8 durchführbar ist.

Im Gegensatz zu dem oben beschriebenen nicht erfindungsgemäßen Referenzbeispiel ist gemäß dem erfinderischen Ausführungsbeispiel vorgesehen, dass anstelle einer elektrischen Kopplung der Schieberelemente 13 bis 16 durch die Ansteuerung der Elektromotoren 20 eine mechanische Kopplung der Schieberelemente 13, 14 beziehungsweise 15, 16 des jeweiligen Paares 11, 12 vorgesehen ist. Dazu können die Schieberelemente 13, 14 beziehungsweise 15, 16 beispielsweise jeweils mit einer gemeinsamen Spindel 21 zusammenwirken. Auch andere mechanische Koppelmöglichkeiten oder entsprechende Getriebe sind denkbar. Hierdurch kann die Anzahl der Elektromotoren 20 verringert und die Ansteuerung der Mittel 10 vereinfacht werden. Die Schieberelemente 13 bis 16 können wie dargestellt als Schieberplatten oder alternativ als Schieberstifte oder Zentrierstifte ausgebildet sein. Insbesondere kann ein Paar 11 oder 12 als Schieberelemente Schieberplatten und das andere Paar 12 beziehungsweise 11 Schieberstifte aufweisen.

## Patentansprüche

1. Drucksystem (1) zum Bedrucken von Substraten (8), insbesondere Leiterplatten, mit einer Druckeinrichtung (2), die wenigstens einen Drucktisch (3) und eine dem Drucktisch (3) zugeordnete Druckschablone (6) aufweist, und mit Mitteln (10) zum Ausrichten eines Substrats (8) auf dem Drucktisch (3), **dadurch gekennzeichnet, dass** die Mittel (10) ein erstes Paar (11) von zwei entlang einer ersten Achse (22) gegenläufig zueinander verlagerbaren ersten Schieberelementen (13,14) und ein zweites Paar (12) von zwei entlang einer zweiten, von der ersten Achse (22) abweichenden Achse (23) gegenläufig zueinander verlagerbaren zweiten Schieberelementen (15,16) aufweisen, wobei jedem Paar (11,12) zumindest eine Antriebseinrichtung (19) zum gleichzeitigen Verlagern seiner Schieberelemente (13-16) zugeordnet ist, und dass die Schieberelemente (13-16) des jeweiligen Paares (11,12) zu ihrer Verlagerung derart mechanisch miteinander gekoppelt sind, dass sie stets gegenläufig zueinander bei der Ansteuerung der Antriebseinrichtung verlagert werden.

2. Drucksystem nach Anspruch 1, **dadurch gekennzeichnet, dass** die erste und zweite Achse (22,23) zumindest im Wesentlichen senkrecht zueinander ausgerichtet sind.

3. Drucksystem nach einem der vorhergehenden Ansprüche, **dadurch gekennzeichnet, dass** jedem Schieberelement (13-16) jeweils eine eigene ansteuerbare Antriebseinrichtung (19) zugeordnet ist.

4. Drucksystem nach einem der vorhergehenden Ansprüche, **dadurch gekennzeichnet, dass** jedem Paar (11,12) von Schieberelementen (13-16) wenigstens ein Sensor zum Erfassen der Stellung zumindest eines der Schieberelemente (13-16) der Paare (11,12) zugeordnet ist.

5. Drucksystem nach einem der vorhergehenden Ansprüche, **gekennzeichnet durch** eine Steuereinheit (S), die die zumindest eine Antriebseinrichtung (19) zumindest eines der Paare (11,12) derart zum Ausrichten des Substrats (8) ansteuert, dass die Schieberelemente (13-16) des Paares (11,12) solange aufeinander zubewegt werden, bis das Substrat zwischen den Schieberelementen (13-16) eingeklemmt ist.

6. Drucksystem nach einem der vorhergehenden Ansprüche, **dadurch gekennzeichnet, dass** die Steuereinheit (S) zunächst das erste Paar (11) und anschließend das zweite Paar (12) von Schieberelementen (13-16) zum sequenziellen Ausrichten des Substrats (8) ansteuert.

7. Drucksystem nach einem der vorhergehenden Ansprüche, **dadurch gekennzeichnet, dass** die Schieberelemente (13-16) in den Drucktisch (3) versenkbar angeordnet sind.

8. Drucksystem nach einem der vorhergehenden Ansprüche, **dadurch gekennzeichnet, dass** die Schieberelemente (13-16) drehbar gelagert angeordnet sind.

9. Verfahren zum Betreiben eines Drucksystems nach einem der Ansprüche 1 bis 8, **dadurch gekennzeichnet, dass** die Schieberelemente (13-16) des ersten Paares (11) aufeinander zu bewegt werden, bis das Substrat (8) zwischen den ersten Schieberelementen (13-14) des ersten Paares (11) geklemmt ist, und dass anschließend die Schieberelemente (15,16) des zweiten Paares (12) aufeinander zubewegt werden, bis das Substrat (8) zwischen den zweiten Schieberelementen (15,16) geklemmt ist.

## Claims

1. A printing system (1) for printing substrates (8), in particular printed circuit boards, comprising a printing device (2) having at least one printing table (3) and a printing template (6) assigned to the printing table (3), and comprising means (10) for aligning a substrate (8) on the printing table (3), **characterized in that** the means (10) have a first pair (11) of first slide elements (13, 14) that can be displaced counter to one another along a first axis (22), and a second pair (12) of second slide elements (15, 16) that can be displaced counter to one another along a second axis (23) which differs from the first axis (22), wherein at least one drive device (19) is assigned to each pair (11, 12) for simultaneously displacing the slide elements (13-16) thereof, and that the slide elements (13-16) of the respective pair (11, 12) on their relocation are mechanically coupled together in such a way that they are always displaced in opposite directions to one another when the drive device is activated.

2. The printing system according to claim 1, **characterized in that** the first and second axes (22, 23) are aligned at least substantially perpendicular to one another.

3. The printing system according to any one of the preceding claims, **characterized in that** each slide element (13-16) is assigned in each case a separate activatable drive device (19).

4. The printing system according to any one of the preceding claims, **characterized in that** each pair (11, 12) of slide elements (13-16) is assigned at least one sensor for detecting the position of at least one of the slide elements (13-16) of the pairs (11, 12).

5. The printing system according to any one of the preceding claims, **characterized by** a control unit (S) which activates the at least one drive device (19) of at least one of the pairs (11, 12) for aligning the substrate (8) in such a manner that the slide elements (13-16) of the pair (11, 12) are moved towards one another until the substrate is clamped between the slide elements (13-16).

6. The printing system according to any one of the preceding claims, **characterized in that** the control unit (S) first activates the first pair (11) and subsequently the second pair of slide elements (13-16) for sequentially aligning the substrate (8).

7. The printing system according to any one of the preceding claims, **characterized in that** the slide elements (13-16) are arranged to be retractable into the printing table (3).

8. The printing system according to any one of the preceding claims, **characterized in that** the slide elements (13-16) are arranged to be mounted rotatably.

9. A method for operating a printing system according to any one of claims 1 to 9, **characterized in that** the slide elements (13-16) of the first pair (11) are moved towards one another until the substrate (8) is clamped between the first slide elements (13-14) of the first pair (11) and that subsequently the slide elements (15, 16) of the second pair (12) are moved towards one another until the substrate (8) is clamped between the second slide elements (15, 16).

## Revendications

1. Système d'impression (1) pour l'impression de substrats (8), en particulier de circuits imprimés, avec un dispositif d'impression (2) qui présente au moins une table d'impression (3) et un gabarit d'impression (6) affecté à la table d'impression (3), et des moyens (10) pour aligner un substrat (8) sur la table d'impression (3), **caractérisé en ce que** les moyens (10) présentent une première paire (11) de deux premiers éléments coulissants (13, 14), déplaçables en sens inverse l'un par rapport à l'autre le long d'un premier axe (22), et une deuxième paire (12) de deux deuxièmes éléments coulissants (15, 16) déplaçables en sens inverse l'un par rapport à l'autre le long d'un deuxième axe (23) s'écartant du premier axe (22), au moins un dispositif d'entraînement (19) pour le déplacement simultané de ses éléments coulissants (13-16) étant affecté à chaque paire (11, 12), et **en ce que** les éléments coulissants (13-16) de chaque paire (11, 12) sont couplés mécaniquement entre eux pour leur déplacement de telle manière à ce qu'ils soient toujours déplacés en sens inverse l'un par rapport à l'autre lors de la commande du dispositif d'entraînement.

2. Système d'impression selon la revendication 1, **caractérisé en ce que** le premier et le deuxième axe (22, 23) sont alignés au moins essentiellement perpendiculairement l'un par rapport à l'autre.

3. Système d'impression selon l'une des revendications précédentes, **caractérisé en ce qu'**un propre dispositif d'entraînement (19) pouvant être commandé est affecté à chaque élément coulissant (13-16).

4. Système d'impression selon l'une des revendications précédentes, **caractérisé en ce qu'**au moins une sonde pour l'enregistrement de la position au moins de l'un des éléments coulissants (13-16) des paires (11, 12) est affectée à chaque paire (11, 12) d'éléments coulissants (13-16).

5. Système d'impression selon l'une des revendications précédentes, **caractérisé par** une unité de commande (S) qui commande, pour l'alignement du substrat (8), au moins un dispositif d'entraînement (19) au moins de l'une des paires (11, 12) de telle manière à ce que les éléments coulissants (13-16) de la paire (11, 12) soient rapprochés l'un de l'autre jusqu'à ce que le substrat soit coincé entre les éléments coulissants (13-16).

6. Système d'impression selon l'une des revendications précédentes, **caractérisé en ce que** l'unité de commande (S) commande d'abord la première paire (11), puis la deuxième paire (12) d'éléments coulissants (13-16) pour l'alignement séquentiel du substrat (8).

7. Système d'impression selon l'une des revendications précédentes, **caractérisé en ce que** les éléments coulissants (13-16) sont disposés de manière escamotable dans la table d'impression (3).

8. Système d'impression selon l'une des revendications précédentes, **caractérisé en ce que** les éléments coulissants (13-16) sont disposés en étant montés en rotation.

9. Procédé pour l'exploitation d'un système d'impression selon l'une des revendications 1 à 8, **caractérisé en ce que** les éléments coulissants (13-16) de la première paire (11) sont rapprochés l'un de l'autre jusqu'à ce que le substrat (8) soit coincé entre les premiers éléments coulissants (13-14) de la première paire (11) et **en ce que** les éléments coulissants (15-16) de la deuxième paire (12) sont ensuite rapprochés l'un de l'autre jusqu'à ce que le substrat (8) soit coincé entre les deux éléments coulissants (15, 16).
